(19) Europäisches Patentamt

European Patent Office

Office européen des brevets

(11) Publication number: **0 138 439**
**B1**

(12) **EUROPEAN PATENT SPECIFICATION**

(45) Date of publication of patent specification: **19.12.90**

(21) Application number: **84306502.0**

(22) Date of filing: **24.09.84**

(51) Int. Cl.⁵: **H 01 L 29/60, G 11 C 17/00**

(54) **Electrically erasable programable nonvolatile semiconductor memory device having dual-control gate.**

(30) Priority: **28.09.83 JP 179560/83**
**28.09.83 JP 179561/83**

(43) Date of publication of application:
**24.04.85 Bulletin 85/17**

(45) Publication of the grant of the patent:
**19.12.90 Bulletin 90/51**

(84) Designated Contracting States:
**DE FR GB**

(56) References cited:
**EP-A-0 019 886**
**EP-A-0 040 377**
**EP-A-0 085 551**
**US-A-4 297 719**

**I.E.E.E. ELECTRO, vol. 8, 18th-20th April 1983, pages 7/4(1-8), New York, US; R. BLANCHARD: "Mosfets in arrays and integrated circuits"**

**ELECTRONICS, vol. 52, no. 4, 15th February 1979, pages 39,40, New York, US; "Programming eased by replacement for ultraviolet E-PROM"**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Shibata, Tadashi c/o Patent Division Kabushiki Kaisha Toshiba 1-1 Shibaura 1-chome Minato-ku Tokyo 105 (JP)**

(74) Representative: **Freed, Arthur Woolf et al MARKS & CLERK 57-60 Lincoln's Inn Fields London WC2A 3LS (GB)**

(56) References cited:
**FUNKSCHAU, vol. 52, no. 4, February 1980, pages 55-58, Munich, DE; A. KUSSMAUL: "Kombination von Logik und nichtflüchtigem Speicher auf einem Chip"**

Courier Press, Leamington Spa, England.

## Description

The present invention relates to an electrically erasable programable nonvolatile semiconductor memory device having a dual-control gate.

In recent EEPROMs (Electrically Erasable Programable Read-Only Memories), dual-control gate type nonvolatile memory cells are widely adopted. In a memory cell of this type, electrons are injected by a tunnel current in an electrically insulated floating gate to update the memory contents. In order to selectively write data in or erase it from these EEPROM cells, a high enough voltage (e.g., 18 V to 25 V) to induce the tunnel current must be selectively applied to the dual-control gate of a desired cell or a semiconductor region for data updating. Each memory cell must have a high dielectric strength against such a high voltage. The requirement presents a big problem to achieve micropatterning and high performance of the memory cell.

The dielectric strength of each cell is mainly determined by the p-n junction between a source or a drain and the substrate. The dielectric strength of the p-n junction depends on a surface breakdown between the source or the drain and the substrate. The surface breakdown tends to occur when a high write/erase voltage is applied to the control gate or the semiconductor region for data updating. In this case, the thickness of the depletion layer formed near a portion of the p-n junction which is in contact with the gate oxide film becomes small, and an electric field is concentrated therein. In order to increase the surface breakdown voltage, the thickness of the gate oxide film under the control gate must be increased, or the junction depth of the source or drain region must be increased. However, this condition prevents micropatterning of the cell. In order to solve this problem, a low impurity concentration diffusion layer is formed in part of the source or drain region located adjacent to the control gate. However, according to this technique, the read rate is decreased and the operating margin is narrowed. In addition to these disadvantages, an additional process for forming the low impurity concentration diffusion layer is required, and an extra area for this low impurity concentration diffusion layer is also required.

It is an object of the present invention to provide an electrically erasable programable nonvolatile semiconductor memory device wherein a sufficiently high dielectric strength can be guaranteed, and memory cells can be micropatterned and highly integrated.

In order to achieve the above object of the present invention, there is provided an electrically erasable programable nonvolatile semiconductor memory device comprising: a first semiconductor region having a plurality of memory cells arranged in a matrix form; a second semiconductor region having a peripheral circuit controlling the plurality of memory cells; insulating means electrically insulating the first semiconductor region from the second semiconductor region;

and potential sustaining means constantly sustaining a data updating region and the first semiconductor region at the same potential when the plurality of memory cells are selectively charged/discharged. Each memory cell has a floating gate, first and second control gates capacitively coupled to the floating gate, source and drain regions, and the data updating region continuously formed with the source or drain region to exchange a charge with the floating gate by a tunnel effect. The source and drain regions and the data updating region have a conductivity type opposite to that of the first semiconductor region. The first and second control gates of the respective memory cells are commonly connected along directions perpendicular to each other in the matrix form.

According to the present invention, the electric field applied to the p-n junction formed by the first semiconductor region and the data updating region for exchanging electrons with the floating gate can be weakened. The first semiconductor region is electrically insulated from the second semiconductor region by the insulating means of high dielectic strength. Therefore, the surface breakdown phenomenon at the memory cell section can be prevented, and the device as a whole can have a high dielectric strength. For this reason, the read rate of the memory cells will not be lowered. In addition to this advantage, the memory cells can be micropatterned and highly integrated without a complicated fabrication process.

Other objects and advantages will be apparent from the following description taken in conjunction with the accompanying drawings, in which:

Fig. 1 is a plan view showing the layout of an electrically erasable programable nonvolatile semiconductor memory according to the present invention;

Fig. 2 is a partial plan view of an electrically erasable programable nonvolatile semiconductor memory device according to a first embodiment of the present invention;

Fig. 3 is a sectional view of the device taken along the line III—III of Fig. 2;

Fig. 4 is a sectional view of the device taken along the line IV—IV of Fig. 2;

Fig. 5 is a partial plan view of an electrically erasable programable nonvolatile semiconductor memory device according to a second embodiment of the present invention;

Fig. 6 is a sectional view of the device taken along the line VI—VI of Fig. 5;

Fig. 7 is a sectional view of the device taken along the line VII—VII of Fig. 5;

Fig. 8 is a partial plan view of an electrically erasable programable nonvolatile semiconductor memory device according to a third embodiment of the present invention;

Fig. 9 is a sectional view of the device taken along the line IX—IX of Fig. 8;

Fig. 10 is a sectional view of the device taken along the line X—X of Fig. 8;

Fig. 11 is a partial plan view of an electrically erasable programable nonvolatile semiconductor memory device according to a fourth embodiment of the present invention;

Fig. 12 is a sectional view of the device taken along the line XII—XII of Fig. 11;

Fig. 13 is a sectional view of the device taken along the line XIII—XIII of Fig. 11;

Fig. 14 is a partial plan view of an electrically erasable programable nonvolatile semiconductor memory device according to a fifth embodiment of the present invention;

Fig. 15 is a sectional view of the device taken along the line XV—XV of Fig. 14; and

Fig. 16 is a sectional view of the device taken along the line XVI—XVI of Fig. 14.

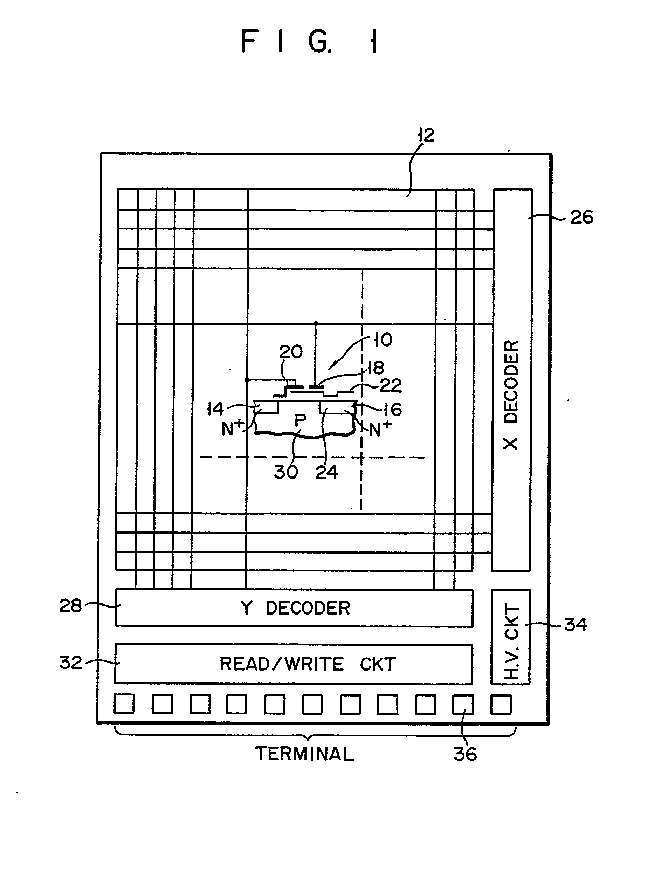

Fig. 1 shows an EEPROM according to the present invention. The EEPROM has a memory cell array 12, and the memory cell array 12 has a plurality of memory cells 10 in a matrix form on a single chip. Each memory cell 10 has source and drain regions 14 and 16, a first control gate 18, a second control gate 20, a floating gate 22 and a data updating region 24 for exchanging electrons with the floating gate 22. The substrate regions of the respective memory cells 10 are constituted by a common semiconductor region 30. The first and second control gates 18 and 20 are capacitively coupled to the floating gate 22. The first control gate 18 is connected to an X decoder 26, and the second control gate 20 is connected to a Y decoder 28. Since each memory cell 10 has the first and second control gates 18 and 20 which are respectively selected by the X and Y decoders 26 and 28, the cell 10 is called a dual-control gate cell (DC cell). In the EEPROM having a plurality of DC cells, electron exchange between the floating gate 22 and the data updating region 24 is performed only in the memory cell 10 where its first and second control gates 18 and 20 have the same potential. The single chip also has a read/write circuit 32 for reading out data from or writing it in the memory cell 10, a high voltage circuit (H.V. CKT) 34 for generating high voltages needed for injecting electrons in or extracting them from the floating gate 22 in the memory cell 10, and a terminal 36. The X decoder 26, the Y decoder 28, the read/write circuit 32, the high voltage circuit 34, and the terminal 36 constitute a peripheral circuit. This peripheral circuit is formed in another semiconductor region electrically insulated from the semiconductor region 30.

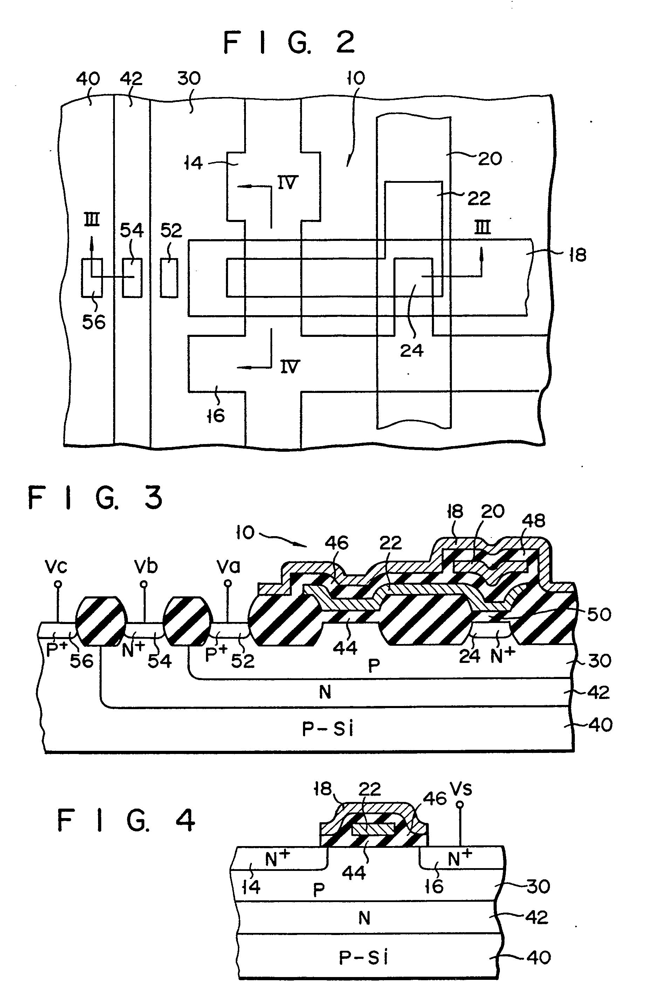

The construction of the memory cell in the peripheral portion of the substrate will be described with reference to Figs. 2 to 4. Only one memory cell in the peripheral portion of the substrate is shown for illustrative convenience. In practice, all of a plurality of memory cells in a matrix form are formed within the p-type semiconductor region 30. An n-type isolation layer 42 is formed in a p-type Si substrate 40, and the p-type semiconductor region 30 is formed on the n-type isolation layer 42. The p-type semiconductor region 30 is surrounded by the n-type isolation layer 42 and is electrically insulated from the substrate 40. The plurality of DC cells 10 are formed in the p-type semiconductor region 30. The DC cells 10 are generally arranged in a matrix form. Each memory cell 10 comprises the n-type source region 14, the n-type drain region 16, the n-type data updating region 24 connected to the drain region 16, the first control gate 18, the second control gate 20, the floating gate 22, and gate oxide films 44, 46, 48 and 50. The source region 14, the drain region 16, and the data updating region 24 are formed in the p-type semiconductor region 30. The second control gate 20 is formed above the floating gate 22, and the first control gate 18 is formed on the second control gate 20. The gate oxide film 44 is formed between the channel region and the floating gate 22. The gate oxide film 46 is formed between the channel region and the first control gate 18, between the drain region 16 and the first control gate 18 and between the floating gate 22 and the first control gate 18. The gate oxide film 48 is formed between the second control gate 20 and the first control gate 18. The gate oxide film 50 is formed between the data updating region 24 and the floating gate 22. A potential Va is supplied to the p-type semiconductor region 30 through a $p^+$-type diffusion layer 52. A potential Vb is supplied to the n-type isolation layer 42 through an $n^+$-type diffusion layer 54. A potential Vc is supplied to the semiconductor substrate 40 through a $p^+$-type diffusion layer 56. A potential Vs is supplied to the drain region 16 and the data updating region 24.

The write/erase operation of the memory cell 10 is performed as follows. The Si substrate 40 is set at a fixed potential Vc = 0 V. When electrons are injected from the data updating region 24 to the floating gate 22 of the memory cell 10, the condition Va = Vb = 0 V is established, and the data updating region 24 is set at the potential Vs of 0 V. A high potential (e.g., 20 V) is applied to the first and second control gates 18 and 20. Electrons are then injected from the data updating region 24 to the floating gate 22 due to the tunnel effect. In this case, a voltage is not applied across the p-n junctions formed between the drain region 16 and the p-type semiconductor region 30 and between the data updating region 24 and semiconductor region 30, thus preventing the surface breakdown. Similarly, a voltage is not applied between the n-type isolation layer 42 and the p-type Si substrate 40, thus preventing the breakdown between the n-type isolation layer 42 and the p-type Si substrate 40.

On the other hand, when the electrons are removed from the floating gate 22 to the data updating region 24, the first and second control gates 18 and 20 are set at 0 V, and the condition Vs = Va = Vb = 20 V is also established. The electrons are shifted from the floating gate 22 to the data updating region 24 by the tunnel effect, thereby completing electron emission. In this case, since a voltage is not applied across the p-n junctions formed between the drain region 16 and the p-type semiconductor region 30 and between the data updating region 24 and the p-type semiconductor region 30, no breakdown occurs. On the other hand, since the p-type Si substrate 40 is set at the potential Vc = 0 V, a high voltage of 20 V is applied across the p-n junction formed by the substrate 40 and the n-type isolation layer 42. It is, however, very easy to increase the dielectric strength of this p-n junction. Even if the junction depth of the n-type isolation layer 42 is as deep as 2 to 10 μm, element characteristics and its micropatterning will not be influenced by the increase in junction depth. Therefore, the dielectric withstand voltage of the p-n junction between the substrate 40 and the n-type isolation layer 42 can become more than 30 V. Alternatively, for obtaining a higher dielectric strength, an n⁻ type layer may be inserted to constitute a p-n junction with the substrate. In this case, unlike the conventional case wherein the respective memory cells have a high dielectric withstand voltage, the packing density of the device will not be decreased.

In order to form such a semiconductor structure, an n-type impurity such as arsenic or phosphorus may be ion-implanted in the p-type Si substrate 40 at an acceleration voltage of 200 to 1,000 kV to form the n-type isolation layer 42 and the p-type semiconductor region 30. Alternatively, an n-type layer may be formed on the p-type substrate 40 by ion implantation or diffusion, a p-type epitaxial layer may be formed thereon, and ion implantation or diffusion is performed with respect to the n-type layer, thereby forming the n-type isolation layer 42 and the p-type semiconductor region 30.

A highly integrated EEPROM having a high dielectric strength can be obtained according to this embodiment of the present invention. In addition to this advantage, since the surface breakdown phenomenon of the memory cell can be effectively prevented, the thickness of the oxide film of the memory cell and the junction depth can be freely selected in accordance with micropatterns of the memory cells based on the scaling rules. The present invention is very effective for micropatterning the memory cells. Unlike the conventional device wherein the dielectric strength is increased by a low impurity concentration diffusion layer, the fabrication process will not be complicated and the read characteristics of the memory cells will not be degraded.

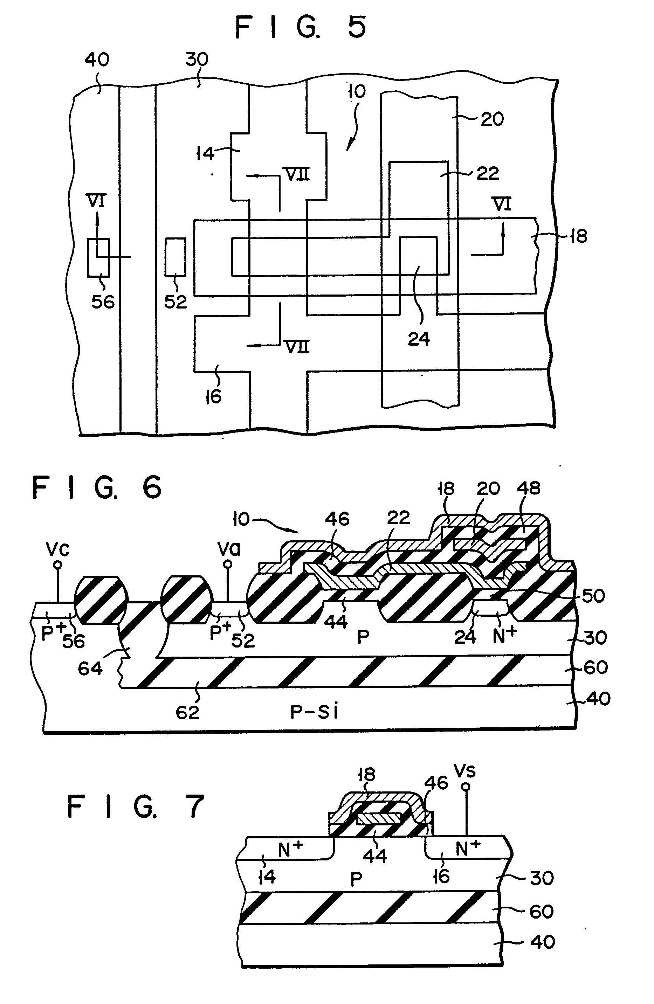

An electrically erasable programable nonvolatile semiconductor memory device according to a second embodiment of the present invention will be described with reference to Figs. 5 to 7. According to the second embodiment, an insulating layer 60 made of silicon oxide ($SiO_2$) is formed between a p-type Si substrate 40 and a p-type common semiconductor region 30. Therefore, the p-type semiconductor region 30 is electrically insulated from the p-type Si substrate 40. Oxygen is ion-implanted in the p-type substrate 40 at a dose of $1 \times 10^{17}/cm^2$ and at an acceleration voltage of 200 kV, and the resultant structure is annealed in a nitrogen atmosphere at a temperature of 1,000°C for about an hour, thereby forming a buried oxide layer 62. The p-type Si substrate 40 is then selectively oxidized to form an oxide region 64 connected to the oxide layer 62, thereby preparing the insulating layer 60. Any other arrangement of the second embodiment is substantially the same as that of the first embodiment. The same reference numerals as in the second embodiment denote the same parts as in the first embodiment, and a detailed description will be omitted.

The write/erase operation of the memory cell will be performed as follows. The Si substrate 40 is set at a fixed potential Vc of 0 V. In order to inject electrons from a data updating region 24 to a floating gate 22 in the memory cell 10, the condition Va = 0 V is established, the data updating region 24 is set at a potential Vs of 0 V, and a high potential (e.g., 20 V) is applied to first and second control gates 18 and 20. The electrons are then injected from the data updating region 24 to the floating gate 22 by the tunnel effect. In this case, a hig voltage is not applied across p-n junctions between the drain region 16 and the p-type semiconductor region 30 and between the data updating region 24 and the p-type semiconductor region 30, thereby preventing the surface breakdown effect. In addition, since the p-type semiconductor region 30 is electrically insulated from the p-type Si substrate 40 through the insulating layer 60, no breakdown occurs.

On the other hand, in order to emit the electrons from the floating gate 22 to the data updating region 24, the first and second control gates 18 and 20 are set at 0 V, and the condition Va = Va = 20 V is established. The electrons are shifted from the floating gate 22 to the data updating region 24 by the tunnel effect. In this case, no voltage is applied across p-n junctions between the drain region 16 and the p-type semiconductor region 30 and between the data updating region 24 and the p-type semiconductor region 30, thereby preventing the breakdown phenomenon. The p-type semiconductor region 30 and the p-type Si substrate 40 are set at 20 V and 0 V, respectively. However, since the p-type semiconductor region 30 is isolated by the insulating layer 60 from the p-type Si substrate 40, no breakdown occurs.

According to the second embodiment, the same effect as in the first embodiment can be obtained.

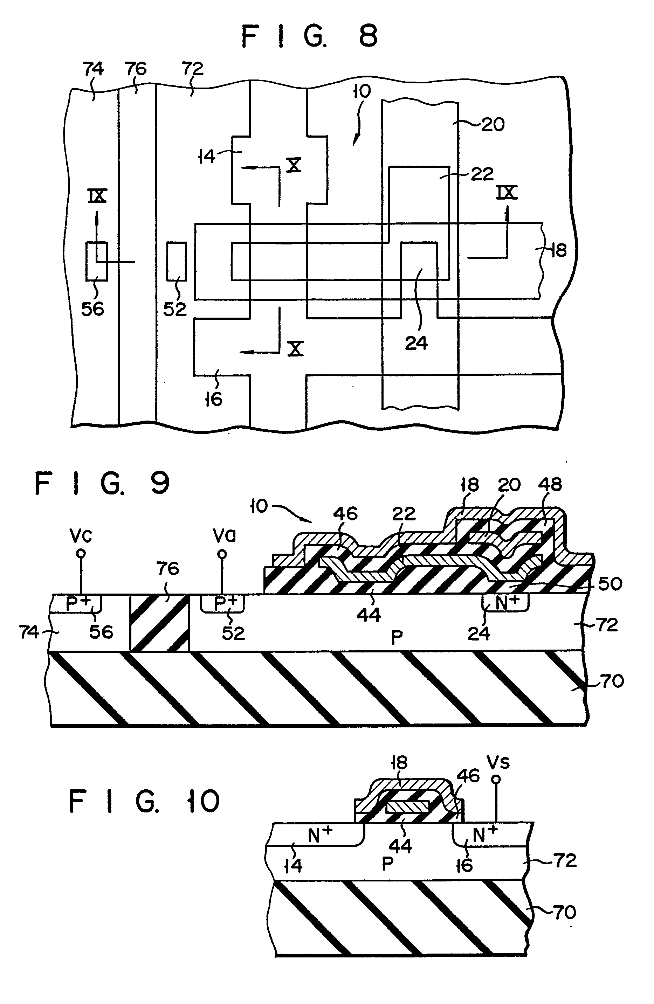

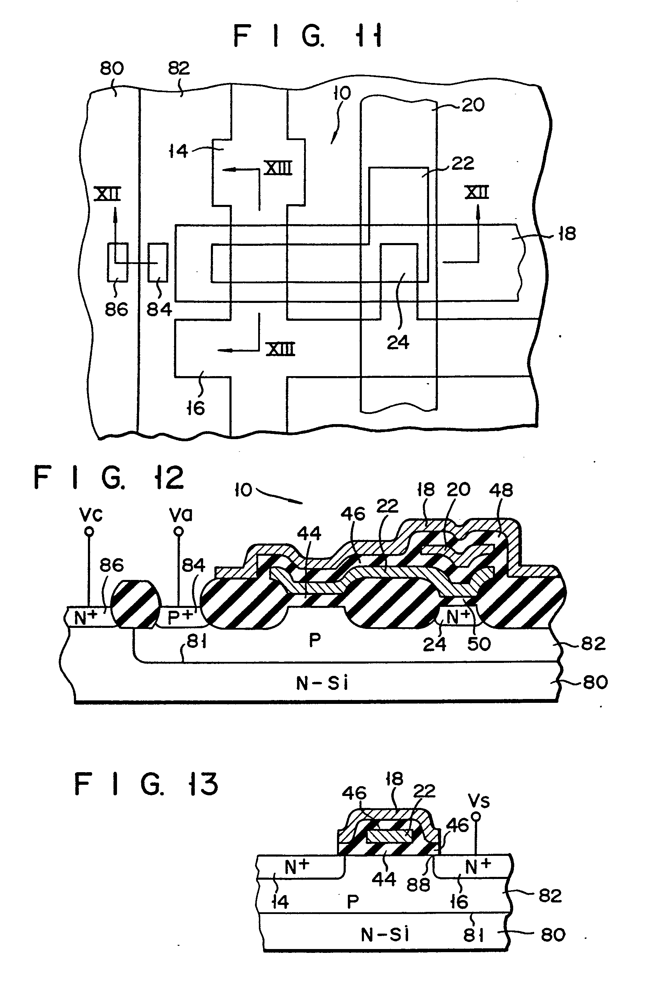

An electrically erasable programable nonvolatile semiconductor memory device according to a third embodiment of the present invention will be described with reference to Figs 8 to 10. A first semiconductor region 72 and a second semiconductor region 74 are formed on an insulating substrate 70 made of, for example, sapphire. The first and second semiconductor regions 72 and 74 constitute silicon islands and are isolated by an insulating region 76. A plurality of memory cells are formed in the first semiconductor region 72 in the same manner as the previous embodiments. A peripheral circuit is formed in the second semiconductor region 74. The cell arrangement of the third embodiment is substantially the same as those of the first and second embodiments. The same reference numerals as in the third embodiment denote the same parts as in first and second embodiments, and a detailed description thereof will be omitted.

When electrons are exchanged between the floating gate 22 and the data updating region 24 in this EEPROM, a voltage (e.g., 20 V) is applied between the floating gate 22 and the data updating region 24. In the case of the write/erase operation, the n-type data updating region 24 is kept at the same potential as that of the p-type first semiconductor region 72. In other words, the potential Vs the n-type data updating region 24 is the same as the potential Va at the first semiconductor region 72. Since no voltage is applied across the p-n junction between the data updating region 24 and the first semiconductor region 72, no surface breakdown will occur in this p-n junction. The potential Vc at the second semiconductor region 74 is normally 0 V. The first semiconductor region 72 is electrically insulated from the second semiconductor region 74 through the insulating substrate 70 and the insulating region 76, thus preventing the breakdown phenomenon. According to the third embodiment, the same effect as in the first embodiment can be obtained.

An electrically erasable programable nonvolatile semiconductor memory device according to a fourth embodiment of the present invention will be described with reference to Figs. 11 to 13. All cells 10 are formed in a p-type well region 82 in an n-type Si substrate 80 in this embodiment. The p-type well region 82 is electrically insulated from the n-type Si substrate 80 through a p-n junction 81 formed between the p-type well region 82 and the n-type Si substrate 80. Each memory cell 10 comprises an n-type source region 14, an n-type drain region 16, an n-type data updating region 24 connected to the drain region 16, a first control gate 18, a second control gate 20, a floating gate 22, and gate oxide films 44, 46, 48 and 50. The source region 14, the drain region 16, and the data updating region 24 are formed in the p-type well region 82. The second control gate 20 is formed above the floating gate 22, and the first control gate 18 is formed above the second control gate 20. The gate oxide film 44 is formed between a channel region and the floating gate 22. The gate oxide film 46 is formed between the channel region and the first control gate 18, between the drain region 16 and the first control gate 18 and between the floating gate 22 and the first control gate 18. The gate oxide film 48 is formed between the second control gate 20 and the first control gate 18. The gate oxide film 50 is formed between the data updating region 24 and the floating gate 22. A potential Va is applied to the p-type well region 82 through a $p^+$-type diffusion layer 84, and a potential Vc is applied to the semiconductor substrate 80 through an $n^+$-type diffusion layer 86. A potential Vs is applied to the drain region 16 and the data updating region 24.

The operation of the memory cell 10 having the arrangement described above will be described.

A potential Vc at the n-type Si substrate 80 is a fixed potential Vdd of +5 V. When electrons are emitted from the floating gate 22 to the data updating region 24, the first and second control gates 18 and 20 are set at a voltage of −15 V, and the data updating region 24 has a potential Vs of +5 V. The electrons are emitted from the floating gate 22 to the data updating region 24 by the tunnel effect, so that the threshold voltage of the memory cell 10 is shifted in the negative direction. In this case, the potential Va at the p-type well region 82 is set to be equal to the potential Vs at the data updating region 24. The p-n junction between the drain region 16 or the data updating region 24 and the p-type well region 82 is not subjected to the surface breakdown. Even if the condition Vs = Va = 5 V is established, the n-type Si substrate 80 is biased at a potential Vc of 5 V. As a result, a current does not flow between the p-type well region 82 and the substrate 80. If the p-type well region 82 is set at the potential of 0 V as in the conventional device and the first and second control gates 18 and 20 are set at −15 V, the thickness of the depletion layer decreases at only a portion 88 located at a position where the p-n junction is in contact with the gate oxide film 46, and an electric field is concentrated therein. The surface breakdown phenomenon tends to occur in a conventional device. However, according to the present invention, since a voltage is not applied across the p-n junction, the electric field is not concentrated, thereby preventing the breakdown phenomenon. When one of the control gates is set at a potential of +5 V, a sufficient potential difference between the floating gate 22 and the data updating region 24 will not be generated, thus disabling emission of electrons.

The case will be described wherein the electrons are injected from the data updating region 24 to the floating gate 22. In this case, the first and second gates 18 and 20 are set at a potential of +5 V, and the data updating region 24 and the p-type well region 82 are respectively set at potentials Vs and Va of −15 V. The electrons are injected from the data updating region 24 to the floating gate by the tunnel effect, so that the threshold voltage of the memory cell is shifted in the positive direction. In this case, the data updating region 24 and the p-type well region 82 are kept at the same potential, and no voltage is applied across the p-n junction therebetween, thereby preventing the surface breakdown phenomenon. Even if a voltage of +20 V is applied to the p-n junction 81 between the p-type well region 82 and the n-type Si substrate 80, it is possible for the well region to have a dielectric withstand voltage of more than 20 V irrespective of micropatterning of the memory cells. Therefore, the breakdown phenomenon will not occur in this p-n junction.

According to the fourth embodiment, the same effect as in the first embodiment can be obtained. In addition, when the p-type well region 82 is formed by using the n-type substrate 80 in the fourth embodiment, a negative potential can be easily generated in the chip. A signal is decoded to easily apply this negative potential to only the necessary control gate. This is because this p-type well region 82 is electrically isolated through the n-type substrate 80 from another well region which is biased to 0 V. Therefore, the p-type well region 82 is charged to generate the negative potential within the chip.

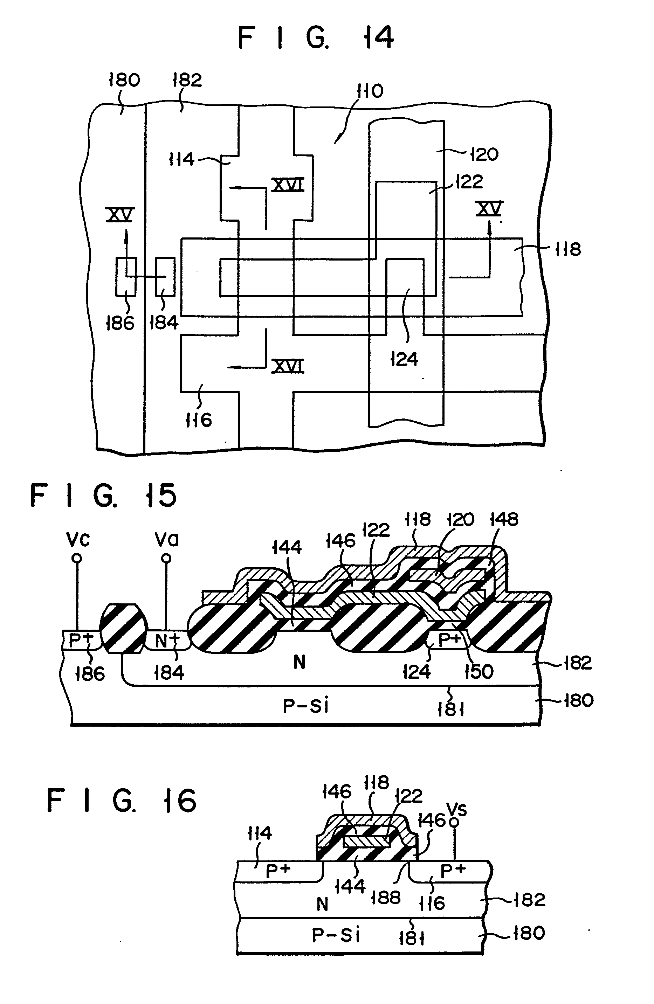

An electrically erasable programable nonvolatile semiconductor memory device according to a fifth embodiment of the present invention will be described with reference to Figs. 14 to 16. The fourth embodiment exemplifies the n-channel memory cells. However, according to the fifth embodiment, memory cells 110 comprise p-channel memory cells. All the memory cells 110 are formed in an n-type well region 182 in a p-type Si substrate 180. The n-type well region 182 is electrically isolated from the p-type Si substrate 180 through a p-n junction 181 between the n-type well region 182 and the p-type Si substrate 180. Each memory cell 110 comprises a p-type source region 114, a p-type drain region 116, a p-type data updating region 124 connected to the drain region 116, a first control gate 118, a second control gate 120, a floating gate 122, and gate oxide films 144, 146, 148 and 150. The source region 114, the drain region 116, and the data updating region 124 are formed within the n-type well region 182. The second control gate 120 is formed above the floating gate 122, and a first control gate 118 is formed above the second control gate 120. The gate oxide film 144 is formed between the channel region and the floating gate 122. The gate oxide film 146 is formed between the channel region and the first control gate 118, between the drain region 116 and the first control gate 118 and between the floating gate 122 and the first control gate 118. The gate oxide film 148 is formed between the second control gate 120 and the first control gate 118. The gate oxide film 150 is formed between the data updating region 124 and the floating gate 122. A potential Va is applied to the n-type well region 182 through an $n^+$-type diffusion layer 184, and a potential Vc is applied to the semiconductor substrate 180 through a $p^+$-type diffusion layer 186. A potential Vs is applied to the drain region 116 and the data updating region 124.

In this embodiment, the potential Vc at the substrate is a fixed potential Vss of 0 V. In order to inject electrons from the data updating region 124 to the floating gate 122, the first and second control gates 118 and 120 are set at a potential of +20 V, and the potential Vs at the data updating region 124 is the ground potential of 0 V. The electrons are injected from the data updating region 24 to the floating gate 122 by the tunnel effect, so that the threshold voltage of the memory cell 110 is shifted in the positive direction. In this case, the potential Va at the n-type well region 182 is the same as the potential Vs at the data updating region 124. The suace breakdown phenomenon does not occur at the p-n junction between the drain region 116 or the data updating region 124 and the n-type well region 182. Even if the condition Vs = Va = 0 V is established, the potential Vc is biased to 0 V. As a result, a current will not flow between the n-type well region 182 and the substrate 180. If the potential at the n-type well region 182 is set at the Vdd potential of +5 V in the same manner as in the conventional device, a voltage of +20 V is applied to the first and second control gates 118 and 120. As a result, the thickness of the depletion layer is thin at a portion 188 located in a position where the p-n junction is in contact with the gate oxide film 146, and thus the electric field is concentrated therein. Therefore, according to the conventional device, the surface breakdown phenomenon tends to occur. However, according to the device of the present invention, since a voltage is not applied across the p-n junction, the electric field is not concentrated, thereby completely preventing the breakdown phenomenon. When one of the control gates is set at 0 V, a sufficient potential difference between the floating gate 122 and the data updating region 124 does not occur, thereby disabling the injection of the electrons.

The case will be described wherein electrons are emitted from the floating gate 122 to the data updating region 124. In this case, the first and second control gates 118 and 120 are set at 0 V, and the potential Vs at the data updating region 124 and the potential Va at the n-type well region 182 are set at a potential of 20 V. The electrons are emitted from the floating gate 122 to the data updating region 124 by the tunnel effect, so that the threshold voltage of the memory cell 110 is shifted in the negative direction. In this case, the data updating region 124 and the n-type well region 182 are kept at the same potential. As a result, no voltage is applied to the p-n junction between the regions 124 and 182, and thus the surface breakdown phenomenon is prevented. The p-n junction 181 between the n-type well region 182 and the p-type Si substrate 180 receives a potential of 20 V. However, the dielectric withstand voltage of the n-type well region 182 can be more than 20 V irrespective of micropattering of the memory cells. Therefore, no breakdown phenomenon will occur.

According to the fifth embodiment of the present invention, the same effect as in the fourth embodiment can be obtained. In the above embodiments, the position of the source may be replaced with that of the drain. In addition, the high voltage for data write/erase operation is not limited to the value exemplified in the above embodiments.

**Claims**

1. An electrically erasable programable nonvolatile semiconductor memory device comprising.

a first semiconductor region (30, 72, 82, 182) having a plurality of memory cells (10, 110) arranged in a matrix form, each of said plurality of memory cells having a floating gate (22, 122), first and second control gates (18, 118; 20, 120) capacitively coupled to said floating gate, source and drain regions (14, 114; 16, 116) and a data updating region (24, 124) formed contiguously with said source or drain region and exchanging a charge with said source or drain region and exchanging a charge with said floating gate by a tunnel effect, said source and drain regions and said data updating region having a conductivity type opposite to that of said first semiconductor region, said first and second control gates of said plurality of memory cells being respectively arranged and commonly connected along orthogonal directions in the matrix form;

a second semiconductor region (40, 74, 80, 180) having a peripheral circuit controlling said plurality of memory cells (10, 110);

insulating means (42, 60, 64, 70, 76, 81, 181) electrically insulating said first semiconductor region (30, 72, 82, 182) from said second semiconductor region (40, 74, 80, 180); and

potential sustaining means (Va, Vs) sustaining said data updating region (24, 124) and said first semiconductor region (30 72 82 182) at the same potential when said data updating region (24, 124) exchanges a charge with said floating gate (22, 122).

2. A nonvolatile semiconductor memory device according to claim 1, characterized in that said first semiconductor region (30) and said second semiconductor region (40) have the same conductivity type, and said insulating means comprises a third semiconductor region (42) formed at the boundary semiconductor region and said second semiconductor region and having a conductivity type opposite to that of said first semiconductor region, said third semiconductor region being kept at the same potential as that of said first semiconductor region when said data updating region exchanges a charge with said floating gate.

3. A nonvolatile semiconductor memory device according to claim 1, characterized in that said insulating means comprises an insulator (60, 62, 64) formed at the boundary between said first semiconductor region (30) and said second semiconductor region (40).

4. A nonvolatile semiconductor memory device according to claim 3, characterized in that said insulator (60, 62, 64) comprises a silicon oxide layer.

5. A nonvolatile semiconductor memory device according to claim 1, characterized in that said first semiconductor region (72) and said second semiconductor region (74) are formed on an insulating substrate (70).

6. A nonvolatile semiconductor memory device according to claim 5, characterized in that said insulating substrate (70) comprises sapphire, and said first and second semiconductor regions (72, 74) comprise silicon islands.

7. A nonvolatile semiconductor memory device according to claim 6, characterized in that said insulating means comprises an insulator (76) formed at the boundary between said first semiconductor region (72) and said second semiconductor region (74).

8. A nonvolatile semiconductor memory device according to claim 7, characterized in that said insulator (76) comprises a silicon oxide layer.

9. A nonvolatile semiconductor memory device according to claim 1, characterized in that said first semiconductor region (82) has a p conductivity type, said second semiconductor region (80) has an n conductivity type, and said first semiconductor region is a p-type well region formed in said second semiconductor region; said insulating means comprises a p-n junction (81) formed between said first semiconductor region and said second semiconductor region; and said potential sustaining means sets said data updating region and said first semiconductor region at the same negative potential when electrons are injected from said n-type data updating region to said floating gate.

10. A nonvolatile semiconductor memory device according to claim 9, characterized in that said potential sustaining means sets said data updating region (24) and said first semiconductor region (82) at ground potential or the same positive potential when the electrons are emitted from said floating gate to said n-type data updating region.

11. A nonvolatile semiconductor memory device according to claim 1, characterized in that said first semiconductor region (182) has an n conductivity type, said second semiconductor region (180) has a p conductivity type, and said first semiconductor region is an n-type well region formed in said second semiconductor region; said insulating means comprises a p-n junction (181) formed between said first semiconductor region and said second semiconductor region; and said potential sustaining means sets said data updating region and said first semiconductor region at the same positive potential when electrons are emitted from said floating gate to said n-type data updating region.

12. A nonvolatile semiconductor memory device according to claim 11, characterized in that said potential sustaining means sets said p-type data updating region (124) and said first semiconductor region (182) at ground potential or the same negative potential when the electrons are injected from said data updating region to said floating gate.

**Patentansprüche**

1. Elektrisch löschbare programmierbare nichtflüchtige Halbleiterspeicheranordnung umfassend:

einen ersten Halbleiterbereich (30, 72, 82, 182) mit einer Anzahl von in einer Matrixform angeordneten Speicherzellen (10, 110), wobei jede der Speicherzellen ein freischwebendes Gate (22, 122), erste und zweite kapazitiv an das freischwebende Gate gekoppelte Steuergates (18, 118; 20, 120), Source- und Drainzonen (14, 114; 16, 116) und einen zusammenhängend mit der Source- oder Drainzone gebildeten und durch einen Tunneleffekt eine Ladung mit dem freischwebenden Gate austauschenden Datenaktualisierungsbereich aufweist, wobei die Source-und Drainzonen und der Datenaktualisierungsbereich einen Leitfähigkeitstyp entgegengesetzt zu demjenigen des ersten Halbleiterbereiches aufweisen, wobei die ersten und zweiten Steuergates der Anzahl von Speicherzellen entsprechend angeordnet und gemeinsam entlang senkrecht aufeinander stehender Richtungen in der Matrixform verbunden sind;

einen zweiten Halbleiterbereich (40, 74, 80, 180) mit einem peripheren Schaltkreis, der die Anzahl Speicherzellen (10, 110) steuert;

eine Isoliereinheit (42, 60, 64, 70, 76, 81, 181), die den ersten Halbleiterbereich (30, 72, 82, 182) von dem zweiten Halbleiterbereich (40, 74, 80, 180) elektrisch isoliert und

eine Potentialaufrechterhaltungseinrichtung (Va, Vs), die den Datenaktualisierungsbereich (24, 124) und den ersten Halbleiterbereich (30, 72, 82, 182) auf demselben Potential hält, wenn der Datenaktualisierungsbereich (24, 124) eine Ladung mit dem freischwebenden Gate (22, 122) austauscht.

2. Nichtflüchtige Halbleiterspeicheranordnung nach Anspruch 1, dadurch gekennzeichnet, daß der erste Halbleiterbereich (30) und der zweite Halbleiterbereich (40) denselben Leitfähigkeitstyp aufweisen und daß die Isoliereinheit einen dritten Halbleiterbereich (42) umfaßt, der an der Grenze zwischen dem ersten Halbleiterbereich und dem zweiten Halbleiterbereich gebildet ist und der einen Leitfähigkeitstyp entgegengesetzt zu demjenigen des ersten Halbleiterbereiches aufweist, wobei der dritte Halbleiterbereich auf demselben Potential wie das(jenige) des ersten Halbleiterbereiches gehalten wird, wenn der Datenaktualisierungsbereich eine Ladung mit dem freischwebenden Gate austauscht.

3. Nichtflüchtige Halbleiterspeicheranordnung nach Anspruch 1, dadurch gekennzeichnet, daß die Isoliereinheit einen an der Grenze zwischen dem ersten Halbleiterbereich (30) und dem zweiten Halbleiterbereich (40) gebildeten Isolator (60, 62, 64) umfaßt.

4. Nichtflüchtige Halbleiterspeicheranordnung nach Anspruch 3, dadurch gekennzeichnet, daß der Isolator (60, 62, 64) eine Siliziumoxidschicht umfaßt.

5. Nichtflüchtige Halbleiterspeicheranordnung nach Anspruch 1, dadurch gekennzeichnet, daß der erste Halbleiterbereich (72) und der zweite Halbleiterbereich (74) auf einem isolierenden Substrat (70) gebildet sind.

6. Nichtflüchtige Halbleiterspeicheranordnung nach Anspruch 5, dadurch gekennzeichnet, daß das isolierende Substrat (70) Saphir enthält und daß die ersten und zweiten Halbleiterbereiche (72, 74) Siliziuminseln enthält.

7. Nichtflüchtige Halbleiterspeicheranordnung nach Anspruch 6, dadurch gekennzeichnet, daß die Isoliereinheit einen an der Grenze zwischen dem ersten Halbleiterbereich (72) und dem zweiten Halbleiterbereich (74) gebildeten Isolator (76) umfaßt.

8. Nichtflüchtige Halbleiterspeicheranordnung nach Anspruch 7, dadurch gekennzeichnet, daß der Isolator (76) eine Siliziumoxidschicht umfaßt.

9. Nichtflüchtige Halbleiterspeicheranordnung nach Anspruch 1, dadurch gekennzeichnet, daß der erste Halbleiterbereich (82) einen p- Leitfähigkeitstyp aufweist, der zweite Halbleiterbereich (80) einen n- Leitfähigkeitstyp aufweist und der erste Halbleiterbereich eine in dem zweiten Halbleiterbereich gebildete Wannenzone des p-Typs ist, daß die Isoliereinheit einen p-n-Übergang (81) umfaßt, der zwischen dem ersten Halbleiterbereich und dem zweiten Halbleiterbereich gebildet ist, und daß die potentialaufrechterhaltungseinrichtung den Datenaktualisierungsbereich und den ersten Halbleiterbereich auf dasselbe negative Potential legt, wenn Elektronen aus dem Datenaktualisierungsbereich des n-Types in das freischwebende Gate injiziert werden.

10. Nichtflüchtige Halbleiterspeicheranordnung nach Anspruch 9, dadurch gekennzeichnet, daß die Potentialaufrechterhaltungseinrichtung den Datenaktualisierungsbereich (24) und den ersten Halbleiterbereich (82) auf Massepotential oder dasselbe positive potential legt, wenn die Elektronen aus dem freischwebenden Gate in den Datenaktualisierungsbereich des n-Types emittiert werden.

11. Nichtflüchtige Halbleiterspeicheranordnung nach Anspruch 1, dadurch gekennzeichnet, daß der erste Halbleiterbereich (182) einen n- Leitfähigkeitstyp aufweist, der zweite Halbleiterbereich (180) einen p- Leitfähigkeitstyp aufweist und der erste Halbleiterbereich eine in dem zweiten Halbleiterbereich gebildete Wannenzone des n- Typs ist, daß die Isoliereinheit einen p-n-Übergang (181) umfaßt, der zwischen dem ersten Halbleiterbereich und dem zweiten Halbleiterbereich gebildet ist, und daß die Potentialaufrechterhaltungseinrichtung den Datenaktualisierungsbereich und den ersten Halbleiterbereich auf dasselbe positive Potential legt, wenn Elektronen aus dem freischwebenden Daten in den Datenaktualisierungsbereich des n-Types emittiert werden.

12. Nichtflüchtige Halbleiterspeicheranordnung nach Anspruch 11, dadurch gekennzeichnet, daß die Potentialaufrechterhaltungseinrichtung den Datenaktualisierungsbereich (124) des p- Typs und den ersten Halbleiterbereich (182) auf Massepotential oder auf dasselbe negative Potential legt, wenn die Elektronen aus dem Datenaktualisierungsbereich in das freischwebende Gate injiziert werden.

**Revendications**

1. Un dispositif de mémoire semi-conducteur non volatil programmable effaçable électriquement comprenant: une première région semi-conductrice (30, 72, 82, 182) ayant une pluralité de cellules de mémoire (10, 110) disposées en forme de matrice, chacune de ladite pluralité de cellules de mémoire ayant une porte flottante (22, 122), une première et une seconde portes de commande (18, 118; 20, 120) couplées capacitivement à ladite porte flottante, des régions de source et de drain (14, 114; 16, 116) et une région de mise à jour de données (24, 124) formées contiguës à ladite région de source ou de drain et échangeant une charge avec ladite porte flottante par une effet tunnel, lesdites régions de source et de drain et ladite région de mise à jour de données ayant un type de condutivité opposé à celui de ladite première région semi-conductrice, lesdites première et seconde portes de commande de ladite pluralité de cellules de mémoire étant respectivement disposées et connectées en commun le long de directions othogonales sous forme de matrice;

une deuxième région semi-conductrice (40, 74, 80, 180) ayant un circuit périphérique commandant ladite pluralité de cellules de mémoire (10, 110);

des moyens isolants (42, 60, 74, 70, 76, 81, 181) qui isolent électriquement ladite première région semi-conductrice (30, 72, 82, 182) de ladite deuxième région semi-conductrice (40, 74, 80, 180); et

des moyens d'entretien de tension (Va, Vs) entretenant ladite région de mise à jour de données (24, 124) et ladite première région semi-conductrice (30, 72, 82, 182) à même tension lorsque ladite région de remise à jour de données (24, 124) échange une charge avec ladite porte flottante (22, 122).

2. Un dispositif de mémoire semi-conducteur non volatil selon la revendication 1, caractérisé en ce que ladite première région semi-conductrice (30) et ladite deuxième semi-conductrice (40) ont le même type de conductivite, et lesdits moyens isolants comprennant une troisième région semi-conductrice (42) formée à liaison entre ladite première région semi-conductrice et ladite deuxième région semi-conductrice et ayant un type de conductivité opposé à cellui de la première région semi-conductrice, ladite troisième région semi-conductrice étant maintenue à la même tension que celle de la première région semi-conductrice lorsque ladite région de remise à jour de données échange une charge avec ladite porte flottante.

3. Un dispositif de mémoire semi-conducteur non volatif selon la revendication 1, caractérisé en ce que lesdits moyens isolants comprennent un isolateur (60, 62, 64) formé à la liaison entre ladite première région semi-conductrice (30) et ladite deuxième région semi-conductrice (40)

4. Un dispositif de mémoire semi-conducteur non volatil selon la revendication 3, caractérisé en ce que ledit isolateur (60, 62, 64) comprend une chouche d'oxyde de silicium.

5. Un dispositif de mémoire semi-conducteur non volatil selon la revendication 1, caractérisé en ce que ladite première région semi-conductrice (72) et ladite seconde région semi-conductrice (74) sont formées sur un substratum isolant 70).

6. Un dispositif se mèoire semi-conducteur non volatil selon la revendication 5, caractérisé en ce que ladite substratum isolant (70) comprend du saphir et lesdites première et deuxième régions semi-conductrices (72, 74) comprennent des flots de silicium.

7. Un dispositif de mémoire semi-conducteur non volatil selon la revendication 6, caractérisé en ce que lesdits moyens isolants comprennent un isolateur (76) formé à la liaison entre ladite première région semi-conductrice (72) et ladite deuxième région semi-conductrice (74).

8. Un dispositif de mémoire semi-conducteur non volatil selon la revendication 7, caractérisé en ce que ledit isolateur (76) comprend une couche d'oxyde de silicium.

9. Un dispositif de mémoire semi-conducteur non volatil selon la revendication 1, caractérisé en ce que ladite première semi-conductrice (82) a une conductivité du type p, ladite deuxième région semi-conductrice (80) a une conductivité du type n, et ladite première région semi-conductrice est une région de puis du type p formée dans ladite deuxième région semi-conductrice; lesdits moyens isolants comprennent une jonction p — n (81) formée entre ladite première région semi-conductrice et ladite deuxième région semi-conductrice; et lesdits moyens d'entretien de tension règlent ladite région de remise à jour de données et ladite première région semi-conductrice à la même tension négative lorsque des électrons sont injectés depuis ladite région de remise à jour de données du type n à ladite porte flottante.

10. Un dispositif se mémoire semi-conducteur non volatil selon la revendication 9, caractérisé en ce que lesdits moyens d'entretien de tension règlent ladite région de remise à jour de données (24) et ladite première région semi-conductrice (82) à la tension de terre ou à la même tension positive lorsque les électrons sont émis depuis ladite porte flottante vers ladite région de remise à jour de donnés du type n.

11. Un dispositif de mémoire semi-conducteur non volatil selon la revendication 1, caractérisé en ce que ladite première région semi-conductrice (182) a une conductivité du type n, ladite deuxième région semi-conductrice (180) a une conductivité du type p, et ladite première région semi-conductrice est une région de puis du type n formée dans ladite deuxième région semi-conductrice; lesdits moyens isolants comprennent une jonction p-n (181) formée entre ladite première région semi-conductrice et ladite deuxième région semi-conductrice; et lesdits moyens d'entretien de tension règlent ladite région de remise à jour de données et ladite première région semi-conductrice à la même tension positive lorsque les électrons sont émis de ladite porte flottante à ladite région de remise à jour de données du type n.

12. Un dispositif de mémoire semi-conducteur non volatil selon la revendication 11, caractérisé en ce que lesdits moyens d'entretien de tension règlent ladite région de remise à jour du type p (124) et ladite première région semi-conductrice (182) à la tension de terre ou à la même tension négative lorsque les électrons sont injectés de puis ladite région de remise à jour de données à ladite porte flottante.

# F I G. 1

# F I G. 2

# F I G. 3

# F I G. 4

# F I G. 5

# F I G. 6

# F I G. 7

# F I G. 8

# F I G. 9

# F I G. 10

# F I G. 11

# F I G. 12

# F I G. 13

# F I G. 14

# F I G. 15

# F I G. 16